# EUROPEAN PATENT APPLICATION

(11) **EP 2 565 655 A1**
(43) Date of publication of application: **06.03.2013**
(21) Application number: 11179563.9
(22) Date of filing: 31.08.2011
(51) Int. Cl.: G01R 31/04, G01R 31/26

(54) **Method for checking a solder joint and arrangement for checking a solder joint**

(71) Applicant: SolarWorld Innovations GmbH, 09599 Freiberg/Sachsen (DE)
(72) Inventor: Storbeck, Olaf, 01109 Dresden (DE); Koch, Christian, 08543 Pöhl (DE)
(74) Representative: Viering, Jentschura & Partner

(57) **Abstract**

Various embodiments provide a method for checking a solder joint, e.g. in a solar cell or photovoltaic cell (102), comprising at least a first conductive structure, a solder and a second conductive structure. The method may include: applying heat, e.g. by a laser (110), to at least a portion of the first conductive structure; measuring temperature, e.g. in a heat image camera (114,116), of a part of the second conductive structure and/or of a part of the first conductive structure; and determining the degree of conductive coupling between the first conductive structure and the second conductive structure based on the applied heat and the measured temperature as a function for the solder joint integrity.

## Description

Various embodiments relate generally to a method for checking a solder joint and to an arrangement for checking a solder joint.

Material joints are produced at various locations during the manufacturing of a photovoltaic module, e.g. a solar module. This may be implemented by coupling pre-soldered metal ribbons (conventionally copper ribbons) with each other or with solar cells or with metal contacts of a connector plug of the photovoltaic module. The quality of such couplings may be determined in a destructing manner (e.g. by means of an attempt of mechanical detachment as a sample check) or by means of acoustic methods (e.g. by means of Scanning Acoustic Microscopy). However, these methods are not suitable for an in-line integrated production control or may detect only coarse gradings, i.e. as to whether a coupling exists or does not exist at all.

Various embodiments provide a method for checking a solder joint including at least a first conductive structure, a solder and a second conductive structure. The method may include applying heat to at least a portion of the first conductive structure; measuring temperature of at least one of a part of the second conductive structure and a part of the first conductive structure; and determining the degree of conductive coupling between the first conductive structure and the second conductive structure based on the applied heat and the measured temperature as a function for the solder joint integrity.

Illustratively, various embodiments provide a measurement method which may be used in the mass production and which additionally registers discrete gradings (e.g. as to whether a complete coupling, partial coupling or no coupling exists).

By heating a portion of the first conductive structure (e.g. at a location at or near the solder joint) and measuring the temperature of a part of the second conductive structure (e.g. at a location at or near the solder joint) or of a part of the first conductive structure (e.g. at a location at or near the solder joint), an accurate determination of the cooling characteristic of the second conductive structure or the first conductive structure and thus of the heat transfer characteristic of the solder joint may be achieved. In various embodiments, the measured temperature and the heat transfer characteristic of the solder joint may be dependent on the solder joint integrity which makes it possible to determine the degree of conductive coupling between the first conductive structure and the second conductive structure in a very easy and contactless manner.

In various embodiments, at least one of the first electrically conductive structure and the second electrically conductive structure may include or consist of metal.

In various embodiments, the first (electrically) conductive structure may include metal selected from a group consisting of Cu; Al; Au; Pt; Ag; Pb; Sn; Fe; Ni; Co; Zn; Ti; Mo; W; Bi; a combination of any one of the above materials; and an alloy of any one of the above materials.

In various embodiments, the second (electrically) conductive structure may include metal selected from a group consisting of Cu; Al; Au; Pt; Ag; Ni; Sn; Ti; Pd; Ta; a combination of any one of the above materials; and an alloy of any one of the above materials.

In various embodiments, the solder joint may be part of a device such as e.g. a photovoltaic cell, e.g. a solar cell. In various embodiments, the first conductive structure may include a solar cell connector wire or solar cell connector ribbon; and the second conductive structure may include a solar cell metallization structure.

In various embodiments, the second conductive structure may include a solar cell metallization structure; wherein the solar cell metallization structure may include a solar cell contact finger.

In various embodiments, the solder joint may be part of a device such as e.g. a solar panel. The first conductive structure may include a solar panel cross connector; and the second conductive structure may include a solar cell connector wire or solar cell connector ribbon.

In various embodiments, the solder joint may be part of a device such as e.g. a solar panel. The first conductive structure may include a solar panel junction box; and the second conductive structure may include a solar panel cross connector.

In various embodiments, the measuring temperature may include measuring a plurality of temperature values; and the plurality of temperature values may be measured at at least one of different times and different locations of the second conductive structure.

In various embodiments, the applying heat may include applying heat by means of a laser.

In various embodiments, the measuring temperature may include measuring the temperature by means of a contact-free sensor.

In various embodiments, the measuring temperature may include measuring the temperature by means of at least one of at least one heat image camera and at least one pyrometer.

In various embodiments, the method may further include determining a temperature trend based on the applied heat and the measured temperature; and/or comparing the temperature trend with a reference heat and a reference temperature trend.

In various embodiments, the (electrically) conductive coupling between the first electrically conductive structure and the second electrically conductive structure may include a metal selected from a group consisting of: Sn; Pb; Ag; Bi; In; Zn; and Cu.

In various embodiments, the applying heat may include heating the portion of the first electrically conductive structure only to a temperature below the melting temperature of the electrically conductive coupling.

In various embodiments, the applying heat may include heating the portion of the first electrically conductive structure to a temperature in the range from about 50 °C to about 270 °C, e.g. to a temperature in the range from about 70 °C to about 250 °C, e.g. to a temperature in the range from about 90 °C to about 230 °C, e.g. to a temperature in the range from about 110 °C to about 210 °C.

In various embodiments, an arrangement for checking a solder joint which includes at least a first conductive structure, a solder and a second conductive structure is provided. The arrangement may include a support structure configured to support the device; a heater configured to apply heat to at least a portion of the first conductive structure; a temperature sensor configured to measure temperature of a part of the second conductive structure or the first conductive structure; and a processor coupled to the heater and the temperature sensor, the processor being configured to determine the degree of conductive coupling between the first conductive structure and the second conductive structure based on the applied heat and the measured temperature.

In various embodiments, the solder joint may be part of a device such as e.g. a solar cell or a solar panel.

In various embodiments, at least one of the first (electrically) conductive structure and the second (electrically) conductive structure may include metal.

In various embodiments, the first conductive structure may include metal selected from a group consisting of Cu; Al; Au; Pt; Ag; Pb; Sn; Fe; Ni; Co; Zn; Ti; Mo; W; Bi; a combination of any one of the above materials; and an alloy of any one of the above materials.

In various embodiments, the second conductive structure may include metal selected from a group consisting of Cu; Al; Au; Pt; Ag; Ni; Sn; Ti; Pd; Ta; a combination of any one of the above materials; and an alloy of any one of the above materials.

In various embodiments, the first conductive structure may include a solar cell connector wire or solar cell connector ribbon or a solar panel cross connector or a solar panel junction box. Furthermore, the second conductive structure may include a solar cell metallization structure or a solar cell connector wire or solar cell connector ribbon or a solar panel cross connector.

In various embodiments, the solar cell metallization structure may include a solar cell contact finger.

In various embodiments, the temperature sensor may be configured to measure a plurality of temperature values.

In various embodiments, the temperature sensor may include a plurality of temperature sensors.

In various embodiments, the temperature sensor may be configured to measure a plurality of temperature values at at least one of different times and different locations of the second electrically conductive structure.

In various embodiments, the heater may include a laser.

In various embodiments, the temperature sensor may include at least one of at least one heat image camera and at least one pyrometer.

In various embodiments, the processor may be configured to determine a temperature trend based on the applied heat and the measured temperature; and to compare the temperature trend with a reference heat and a reference temperature trend (which may be assigned to the corresponding reference heat which was applied and resulted in the respective reference temperature trend).

In various embodiments, the (electrically) conductive coupling between the first electrically conductive structure and the second electrically conductive structure may include a solder coupling. In various embodiments, the solder coupling may include a soft solder coupling. In various embodiments, the soft solder coupling may include a metal selected from a group consisting of: Sn; Pb; Ag; Bi; In; Zn; and Cu.

In various embodiments, the heater may be configured to heat the portion of the first electrically conductive structure only to a temperature below the melting temperature of the (electrically) conductive coupling.

In various embodiments, the heater may be configured to heat the portion of the first electrically conductive structure to a temperature in the range from about 50 °C to about 270 °C, e.g. to a temperature in the range from about 70 °C to about 250 °C, e.g. to a temperature in the range from about 90 °C to about 230 °C, e.g. to a temperature in the range from about 110 °C to about 210 °C.

In the drawings, like reference characters generally refer to the same parts throughout the different views. The drawings are not necessarily to scale, emphasis instead generally being placed upon illustrating the principles of the invention. In the following description, various embodiments of the invention are described with reference to the following drawings, in which:
FIG. 1 shows an arrangement for checking a solder joint in accordance with various embodiments;
FIG. 2 shows a flow diagram illustrating a method for checking the solder joint in accordance with various embodiments;
FIG. 3 shows a top view of a solder joint illustrating a method for checking the solder joint in accordance with various embodiments;
FIG. 4 shows experimentally determined temperature-time-characteristics of solar cell connectors which are coupled with cross connectors s with different coupling qualities in accordance with various embodiments; and
FIG. 5 shows a top view of a solder joint illustrating a method for checking the solder joint in accordance with various embodiments.

The following detailed description refers to the accompanying drawings that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

Various embodiments illustratively provide a combination of a local heat source (e.g. implemented by means of a laser source, e.g. an infrared laser source) with one or more temperature sensors (e.g. implemented by means of one or more pyrometers and/or one or more heat image cameras). In various embodiments, a material engagement may be formed (and thus a solder joint) by a first solder partner material (also referred to as a first material to be soldered or as first (electrically) conductive structure), a second solder partner material (also referred to as a second material to be soldered or as second (electrically) conductive structure), and solder therebetween.

It is to be mentioned that various embodiments may be applied to any application in which a solder joint between two or more materials soldered together by means of the solder joint should be determined or checked. Keeping this general approach in mind, the following embodiments illustrate the non-limiting application of various embodiments to the technical field of photovoltaic modules or photovoltaic cells, e.g. solar modules or solar cells.

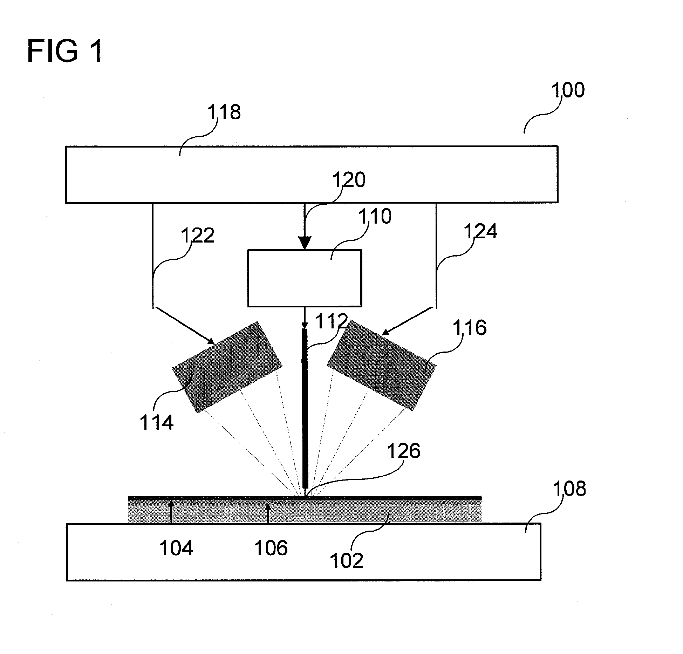

FIG. 1 shows an arrangement 100 for checking a solder joint in accordance with various embodiments. In various embodiments, one or more photovoltaic cells 102 (in FIG. 1 shown in cross sectional view, optionally including a metallization structure such as so-call contact fingers and/or one or more busbars) may be provided.

A photovoltaic cell 102 may include a substrate. Furthermore, the substrate may include or consist of at least one photovoltaic layer. As an alternative, at least one photovoltaic layer may be disposed on or over the substrate. The photovoltaic layer may include or consist of semiconductor material (such as e.g. silicon), a compound semiconductor material (such as e.g. a III-V compound semiconductor material (such as e.g. GaAs), a II-VI semiconductor material (such as e.g. CdTe), a I-III-V compound semiconductor material (such as e.g. copper indium disulfide)). As an alternative, the photovoltaic layer may include or consist of an organic material. In various embodiments, the silicon may include or consist of single-crystalline silicon, polycrystalline silicon, amorphous silicon, and/or microcrystalline silicon. The photovoltaic layer may include a semiconductor junction structure such as e.g. a pn-junction structure, a pin-junction structure, a Schottky type junction structure, and the like.

Furthermore, in various embodiments, the photovoltaic layer may include or consist of a thin semiconductor film. In this case, the thin semiconductor film may be disposed on or over the substrate, which may include or consist of e.g. a glass plate.

In various embodiments, a metallization structure such as so-call contact fingers and/or one or more busbars may be provided on the upper surface of the photovoltaic cell 102. The metallization structure and/or one or more busbars may be provided as a respective second (electrically) conductive structure.

Furthermore, in various embodiments, one or more cell connectors 104, e.g. implemented as cell connector ribbons and/or as cell connector wires may be provided as a respective first (electrically) conductive structure.

The cell connector ribbon(s) or the cell connector wire(s) may be configured to collect and transmit electric power generated by the at least one photovoltaic layer. The cell connector ribbon(s) or the cell connector wire(s) may include or consist of electrically conductive material, e.g. metallically conductive material. In various embodiments, the cell connector ribbon(s) or the cell connector wire(s) may include or consist of a metallic material, which may include or consist of one or more of the following metals: Cu, Al, Au, Pt, Ag, Pb, Sn, Fe, Ni, Co, Zn, Ti, Mo, W, and/or Bi. In various embodiments, the cell connector ribbon(s) or the cell connector wire(s) may include or consist of a metal selected from a group consisting of: Cu, Au, Ag, Pb, and Sn.

The cell connector ribbon(s) or the cell connector wire(s) may in general have an arbitrary cross-section such as e.g. a round form, an oval form, a triangle form, a rectangular (e.g. square) form, or any other polygonal form.

A light-transparent electrically conductive layer may optionally be disposed on or over the at least one photovoltaic layer. The light-transparent electrically conductive layer may include, for example, a thin film including indium-tin-oxide or tin-oxide (which may be formed by means of sputtering, for example).

In various embodiments, the one or more cell connectors 104 are soldered to the metallization structure such as so-call contact fingers and/or one or more busbars of the photovoltaic cell 102 (in general to the front surface of the photovoltaic cell 102) by means of a solder coupling 106. In various embodiments, the solder coupling 106 may include or consist of Sn; Pb; Ag; Bi; In; Zn; Cu; and/or Ni, SnPb, SnCu, SnIn, SnCuAg, SnPbAg, SnBi.

A photovoltaic cell module (e.g. a solar cell module) may be provided by electrically serially connecting a plurality of photovoltaic cells (e.g. solar cells) (e.g. by means of the one or more cell connectors 104) to obtain a photovoltaic cell string and sealing the photovoltaic cell string e.g. by a covering material into a module form.

In various embodiments, as shown in FIG. 1, the arrangement 100 may include a carrier 108 configured to carry the one or more photovoltaic cells 102 (e.g. one or more solar cells 102). The carrier 108 may include a transport structure (e.g. including one or more motors and one or more conveyors) to transport the one or more photovoltaic cells 102 to the arrangement 100 and out of the arrangement 100.

After the soldering has been carried out, the thereby formed solder joint(s) is/are to be tested. This may be carried out by means of a local heating of the respective solder coupling 106 to be tested. The term "local heating" may be understood in various embodiments such that a location at or near the solder joint 106 to be tested will be heated by means of a heater 110, e.g. implemented as a laser source or as any other suitable heat source. In the case of a laser source as the heater 110, the laser source 110 irradiates a laser beam 112 onto a location 126 to be heated. In various embodiments, the location 126 to be heated may be on or near the first conductive structure, e.g. on or near the one or more cell connectors 104.

In other words, the first joint partner material (e.g. the first conductive structure, e.g. the one or more cell connectors 104, which may be implemented in a cell connector being coating with solderable material such as with a solder material which is also used for the solder joint 106 (the solderable material may include or consist of Ag, Sn and/or Ni and/or Sn, SnPb, SnCu, SnCuAg, SnPbAg, SnIn, SnBi), or in a solar panel cross connector or in a solar panel junction box) may be heated locally in the region of the solder coupling 106. In various embodiments, the heating may be carried out e.g. on the first conductive structure directly above the solder coupling 106 or next to the solder coupling 106, e.g. in a region being arranged at a distance from a center of the solder coupling 106 in the range from abut 1 mm to about 50 mm, e.g. in the range from abut 2 mm to about 20 mm, in the range from abut 5 mm to about 10 mm.

The brought-in heat may flow through the solder coupling 106 (e.g. a solder layer) towards the second joint partner material (e.g. the metallization structure such as so-call contact fingers and/or one or more busbars and/or a solar panel cross connector). In various embodiments, the temperature at or near the first joint partner material and/or at or near the second joint partner material may be detected by means of one or more temperature sensors 114, 116 (FIG. 1 shows a first temperature sensor 114 and a second temperature sensor 116, although in other embodiments, also only one or even more than two, e.g. three, four, five, six, or even more temperature sensors may be provided). In various embodiments, the one or more temperature sensors 114, 116 may be implemented as contact-free temperature sensors 114, 116, such as e.g. as one or more pyrometers and/or as one or more heat image cameras.

The arrangement 100 may further include a processor 118, which may be wiredly or wirelessly coupled to the heater 110 (e.g. via a first communication connection 120; thus, the processor 118 may control the heating of the heater 110) and/or to the temperature sensors 114, 116 (e.g. via a second communication connection 122 and a third communication connection 124, respectively; thus, the processor 118 may switch the temperature sensors 114, 116 on and off and may control the transmission of the temperature values detected by the one or more temperature sensors 114, 116). The processor 118 may be implemented by means of any kind of logic, e.g. by means of a hardwired logic or a microprocessor and corresponding software, or in a hybrid manner, i.e. by means of a hardwired logic and a microprocessor and corresponding software. It is to be mentioned that the evaluation of the detected temperatures may also be carried out by means of a circuit or logic separate from the processor 118. Thus, in various embodiments, one or more additional processors (not shown in FIG. 1) may be provided and coupled e.g. to the temperature sensors 114, 116 (in which case e.g. the processor 118 may not necessarily be coupled to the temperature sensors 114, 116).

In various embodiments, the processor 118 (or any other kind of circuit or logic which receives the detected one or more temperature values from the temperature sensors 114, 116) may carry out an evaluation process to check the solder joint. In general terms, the processor 118 evaluates the heating characteristic and/or the cooling characteristic of the first joint partner material and/or the second joint partner material, depending on the arrangement of the heater 110 and the temperature sensors 114, 116. The processor 118 may include a central processing unit (CPU), a random access memory (RAM) and a read only memory (ROM) and any other components or circuits as desired. The control software may be stored in the ROM and may be carried out by the CPU. The control software may include an implementation of the method which will be described in more detail below.

In various embodiments, one or more calibration curves of temperature characteristics for a solder joint without damage, for a solder joint which one or more damages, in other words a solder joint with reduced temperature conductivity compared with the solder joint without damage, and/or for a completely damaged solder joint, in other words for a non existing solder coupling (which may have an even lower temperature conductivity compared with the solder joint without damage or with one or more damages). These pre-determined temperature characteristics (which may be determined for one or more reference cells or for the same cell for which the state of the respective solder joint is already known (e.g. determined with a different method such as e.g. an xray method)) may be stored in the RAM.

In general terms, in various embodiments, the processor 118 evaluates the heating characteristic and/or the cooling characteristic of the first joint partner material and/or the second joint partner material detected by the one or more temperature sensors 114, 116. The detected temperature characteristics will be different from one another due to the different qualities of the respective solder joints being examined, in other words, due to the different actual filling of the possible contact area(s) between the first joint partner material and the solder and/or the second joint partner material and the solder. These different heat propagation resistances are the basis from which the quality of the solder joint may be determined. In other words, the quality of the solder joint is a function of the heat propagation resistance of the first joint partner material, the solder, and/or the second joint partner material. It is to be noted that this measurement principle may be applied in a running mass production of a solder process, e.g. in a running mass production of photovoltaic modules such as e.g. solar modules, since a sufficiently short measurement and evaluation time may be achieved in various embodiments (in various embodiments, a measurement and evaluation time in the range of one or more seconds per solder joint may be achieved).

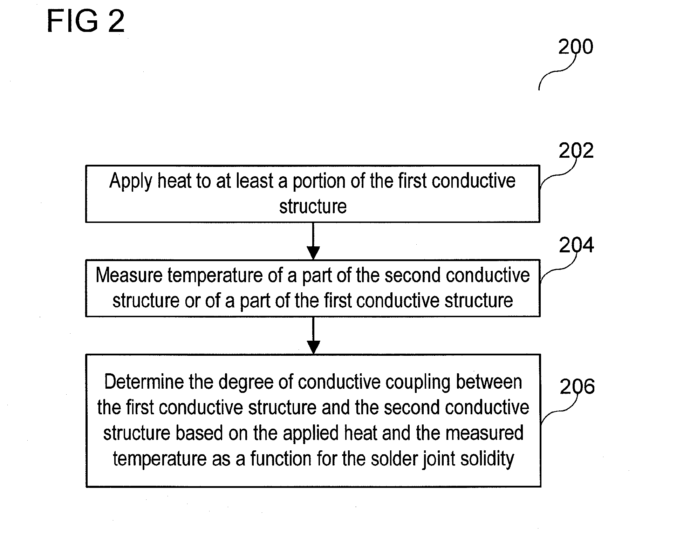

As shown in FIG. 2, in various embodiments, the method 200 for checking a solder joint, which may include at least a first conductive structure, a solder and a second conductive structure, may include, in 202, applying heat to at least a portion of the first conductive structure 104 (e.g. by means of the heater 110). In various embodiment, heat may be applied such that e.g. the first conductive structure 104 may be heated up to a temperature in the range from about 50 °C to about 270 °C, e.g. up to a temperature in the range from about 70 °C to about 250 °C, e.g. up to a temperature in the range from about 90 °C to about 230 °C, e.g. up to a temperature in the range from about 110 °C to about 210 °C. In various embodiments, the portion of the first electrically conductive structure 104 may be only heated to a temperature below the melting temperature of the solder 106.

Furthermore, in various embodiments, in 204, temperature of a part of the second conductive structure 102 or of a part of the first conductive structure 104 may be measured (the part of the first conductive structure 104 would be different from the portion to which the heat is applied and at least a portion of the solder would be arranged between the portion to which the heat is applied and the part of the first conductive structure 104 where the temperature is detected or measured). In various embodiments, one or more temperature values may be measured during the measuring process. Furthermore, in various embodiments, the plurality of temperature values may be measured at different times (i.e. at different time instants) and/or at different locations of the second conductive structure or the first conductive structure.

Furthermore, the method may include, in 206, determining the degree of conductive coupling between the first conductive structure 104 and the second conductive structure 102 based on the applied heat and the measured temperature as a function for the solder joint solidity.

As described above, the first conductive structure 104 may include or consist of metal such as e.g. Cu, Al, Au, Pt, Ag, Pb, Sn, Fe, Ni, Co, Zn, Ti, Mo, W, and/or Bi. The first conductive structure 104 may be coated with solderable material as described above. Furthermore, in various embodiments, the second conductive structure (e.g. the metallization structure and/or one or more busbars) may also include or consist of metal such as e.g. Cu; Al; Au; Pt; Ag; Ni; Sn; Ti; Pd; Ta; a combination of any one of the above materials; and an alloy of any one of the above materials. In various embodiments, the solder 106 illustratively couples the first conductive structure 104 with the second conductive structure.

In various embodiments, a temperature trend (in other words, temperature characteristic) may be determined based on the applied heat and the measured temperature. The determined temperature trend may then be compared with a reference heat and a reference temperature trend associated with the respective reference heat (such as e.g. the above described previously determined and stored one or more calibration curves of temperature characteristics stored in the RAM). In various embodiments, it may be provided that not the entire temperature trend is determined and compared but only a few specific temperature values (e.g. the temperature peak values of the measured temperature values) are compared with the previously determined and stored one or more calibration curves of temperature characteristics stored in the RAM; in this case, only the peak values of the calibration curve(s) may be stored. Depending on the comparison result, the quality of the solder joint (in general, the degree of conductive coupling) may be determined.

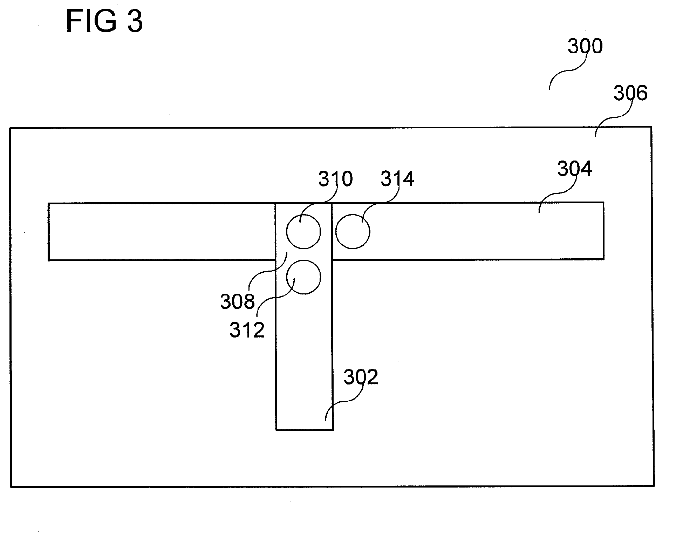

FIG. 3 shows a top view 300 of a solder joint illustrating a method for checking the solder joint in accordance with various embodiments. As shown in FIG. 3, a cross contact (as an implementation of a conductive coupling, e.g. solder, e.g. 106) may be provided and the degree of the cross contact (in other words its quality) should be determined. A cross contact may be understood as a connection between a so-called cell connector 302 (as an implementation of the first conductive structure 104) and a cross connector 304 (as an implementation of the second conductive structure) (FIG. 3 shows a carrier 306, implemented as an EVA/glass support carrying the cell connector 302 and the cross connector 304). In various embodiments, the cell connector 302 and the cross connector 304 include or consist of Cu ribbons or Cu wires, wherein the cell connector 302 and/or the cross connector 304 may be coated with a soft solder. This enables a coupling of the cell connector 302 and the cross connector 304 by means of a solder process. The cell connector 302 is provided for the coupling of two or more individual photovoltaic cells (e.g. solar cells) und at the same time provide an electrically conductive connection. The cell connector 302 may be coupled to the cross connector 304, which in turn terminates in a junction box (not shown in FIG.3), which is configured to dissipate the electrical energy from the photovoltaic module (e.g. the solar cell module). In variuos embodiments, the cell connector 302 and the cross connector 304 may be arranged in angle with each other, e.g. in an angle of about 90 °, e.g. they are arranged perpendicular to each other.

In various embodiments, the quality of the, e.g. solder, coupling between the cell connector 302 and the cross connector 304 may be determined as follows: The cell connector 302 and the cross connector 304 are soldered to each other at a solder region at a crossing region 308 of the cell connector 302 and the cross connector 304 between the cell connector 302 and the cross connector 304. One of the conductive structures, e.g. the cell connector 302 or the cross connector 304 are locally heated (e.g. by means of a laser), e.g. at a locally limited heating region 310 on one of the conductive structures. As already described above, the heating may be limited to a temperature below the melting temperature point of the material of the coupling, e.g. below the melting temperature point of the solder. Furthermore, the heating may be limited to a temperature below the crosslinking temperature point of the module foil formed by the carrier 306. In various embodiments, the second solder partner material illustratively functions as a cooling device in this case, which dissipates the heat differently depending on the completeness (in other words, dependent on the quality or degree) of the coupling, e.g. the solder coupling. The temperature characteristic of one or both solder partner materials (e.g. of the first conductive structure (e.g. at a first measurement location 312) and/or the second conductive structure (e.g. at a second measurement location 314)) will simultaneously detected (and e.g. recorded) by means of sensors (e.g. contactless sensors, e.g. implemented as pyrometers).

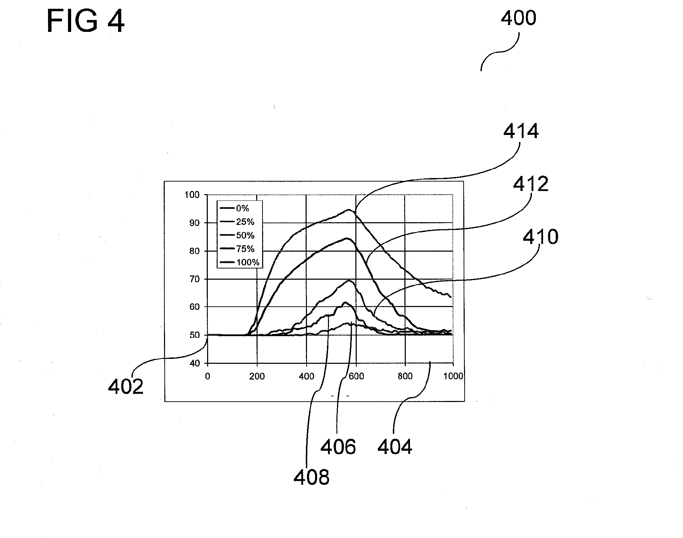

The higher the quality or degree of the coupling (e.g. the solder), the better will the heat be transferred to the opposite solder partner material. This dependency is illustratively shown in a diagram 400, which shows experimentally determined temperature-time-characteristics of solar cell connectors which are coupled with cross connectors with different coupling qualities in accordance with various embodiments. As shown in FIG. 4, the diagram 400 includes the dependency of the cell connector temperature (in degree Celsius (°C)) (shown along a first axis 402) from the time (in ms) (shown along a second axis 404). The % values represent the area ratio of the current solder coupling compared with a complete solder coupling.

- A first temperature characteristic 406 representing a 100% fully existing and complete coupling (e.g. solder connection between the first conductive structure 302 and the second conductive structure 304 having a quality or degree of 100 %) shows only a small increase of the temperature in response to the heating and a fast recovery to the environment temperature.

- A second temperature characteristic 408 representing a 75 % coupling (e.g. solder connection between the first conductive structure 302 and the second conductive structure 304 having a quality or degree of 75 %) already shows a higher increase of the temperature in response to the heating than the first temperature characteristic 406 and a slower recovery to the environment temperature, thereby indicating a worse heat transfer than in accordance witht the first temperature characteristic 406, which means a coupling with less conductive material (in other words with more damages) between the first conductive structure 302 and the second conductive structure 304.

- A third temperature characteristic 410 representing a 50 % coupling (e.g. solder connection between the first conductive structure 302 and the second conductive structure 304 having a quality or degree of 50 %) shows an even higher increase of the temperature in response to the heating than the first temperature characteristic 406 and the second temperature characteristic 408 and a slower recovery to the environment temperature, thereby indicating an even worse heat transfer than in accordance witht the first temperature characteristic 406 and second temperature characteristic 408, which means a coupling with even less conductive material (in other words with even more damages) between the first conductive structure 302 and the second conductive structure 304.

- A fourth temperature characteristic 412 representing a 25 % coupling (e.g. solder connection between the first conductive structure 302 and the second conductive structure 304 having a quality or degree of 25 %) shows a yet even higher increase of the temperature in response to the heating than the first temperature characteristic 406, the second temperature characteristic 408 and the third temperature characteristic 410 and a slower recovery to the environment temperature, thereby indicating a yet even worse heat transfer than in accordance witht the already mentioned temperature characteristics 406, 408, 410, which means a coupling with even less conductive material (in other words with even more damages) between the first conductive structure 302 and the second conductive structure 304.

- A fifth temperature characteristic 414 representing a 0 % coupling, in other words non-existing coupling (e.g. solder connection between the first conductive structure 302 and the second conductive structure 304 having a quality or degree of 0 %) shows a yet even higher increase of the temperature in response to the heating than the first temperature characteristic 406, the second temperature characteristic 408, the third temperature characteristic 410 and the fourth temperature characteristic 412 and a slower recovery to the environment temperature, thereby indicating a yet even worse heat transfer than in accordance witht the already mentioned temperature characteristics 406, 408, 410, 412, which means a coupling with even less conductive material (in other words with even more damages) between the first conductive structure 302 and the second conductive structure 304.

In various embodiments, one or more series of measurements using selectivley set probes may be used to determine one or more calibration curves of temperature characteristics. Thus, the coupling quality may continuously be determined.

In various embodiments, in case the coupling is determined to be too bad (e.g. lower than 50 %) and/or in case too many couplings in a cell, string or module are determined to be too bad (e.g. a predefined number of couplings in a cell, a predefined number of couplings in a string, and/or a predefined number of couplings in a module) the respective cell, string or module or forerunner module may be discharged and repaired or disposed of.

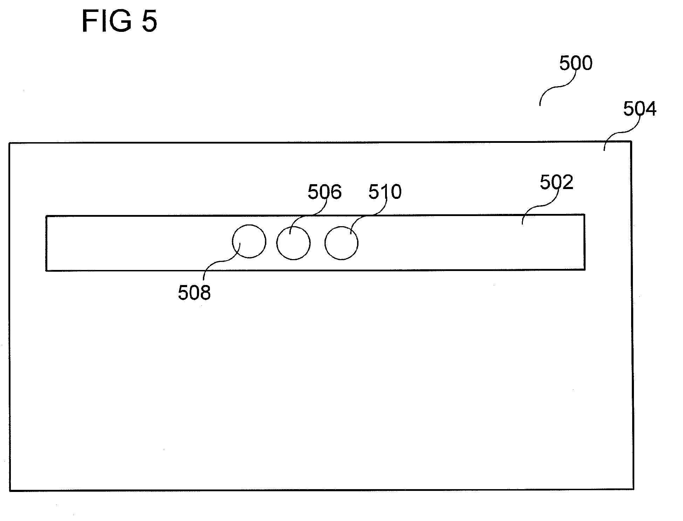

FIG. 5 shows a top view 500 of a solder joint illustrating a method for checking the solder joint in accordance with various embodiments, wherein the photovoltaic cell solder couplings are checked.

In various embodiments, individual (e.g. crystalline or polycrystalline) photovoltaic cells may be electrically connected in series and mechanically coupled with each other by means of so-called one or more cell connectors 502 (such as e.g. cell connector wires and/or cell connector ribbons, e.g. implemented as soldered metal band). In this case, the one or more cell connectors 502 are laid onto a solderable cell surface region of a photovoltaic cell 504 and will be soldered by heating the structure.

In various embodiments, the respective degree of the couplings may be determined by running the sensor(s) and the heater 110 along the respectively checked cell connector 502, as shown in FIG. 5. In various embodiments, the heater 110 may move relative to the cell 504 (i.e. the heater may be fixed and the cell 504 may be moved or the cell 504 may be fixed and the heater 110 may be moved or both the heater 110 and the cell 504 may be moved, but with different speeds). Thus, the cell connector 502 may be locally heated, e.g. at a locally limited heating region 506 on or near the cell connector 502.

As already described above, the heating may be limited to a temperature below the melting temperature point of the material of the coupling, e.g. below the melting temperature point of the solder. Furthermore, the heating may be limited to a temperature below a temperature which would damage the cell 502 itself. In various embodiments, the second solder partner material and the cell 502 itself illustratively function as a cooling device in this case, e.g. via the solder layer e.g. solder layer 106, which dissipates the heat differently depending on the completeness (in other words, dependent on the quality or degree) of the coupling, e.g. the solder coupling. The temperature characteristic of one or both solder partner materials (e.g. of the first conductive structure (e.g. at a first measurement location 508, which may be located before (relative to the movement of) the heating region 506) and/or the second conductive structure (e.g. at a second measurement location 510, which may be located after (relative to the movement of) the heating region 506)) will simultaneously detected (and e.g. recorded) by means of sensors (e.g. contactless sensors, e.g. implemented as pyrometers), e.g. on the cell connector 502 and then evaluated, e.g. by the processor 118.

The heat conduction resistance varies depending on the coupling quality, as generally described above. Thus, in various embodiments, badly coupled cells or cell strings (i.e. rows of cell coupled in series) may be determined and may be discharged and repaired or disposed of.

Various embodiments provide a method for checking one or more solder contacts between metal bands and/or metal wires.

Various embodiments provide a method for checking one or more solder contacts between metal bands and/or metal wires and photovoltaic cells.

In various embodiments, the solder may be formed as a solder layer including or consisting of soft solder having portions of Sn, Pb, Ag, Bi, In, Zn or Cu.

In various embodiments, the local heating of the solder partner materials may be limited to a temperature below the melting point temperature of the solder material (e.g. to a range from about 100 °C to about 240 °C).

Various embodiments determine the quality of a coupling using the heat conduction resistance.

Various embodiments allow a continuous in-line process control of each one of the solder joints including all advantages of a statistic process control (SPC).

While the invention has been particularly shown and described with reference to specific embodiments, it should be understood by those skilled in the art that various changes in form and detail may be made therein without departing from the spirit and scope of the invention as defined by the appended claims. The scope of the invention is thus indicated by the appended claims and all changes which come within the meaning and range of equivalency of the claims are therefore intended to be embraced.

## Claims

1. A method (200) for checking a solder joint comprising at least a first conductive structure, a conductive coupling and a second conductive structure, the method (200) comprising:
applying heat to at least a portion of the first conductive structure (202);
measuring temperature of at least one of a part of the second conductive structure and a part of the first conductive structure (204); and
determining the degree of conductive coupling between the first conductive structure and the second conductive structure based on the applied heat and the measured temperature as a function for the solder joint solidity (206).

2. The method (200) of claim 1,
wherein at least one of the first electrically conductive structure and the second electrically conductive structure comprises metal.

3. The method (200) of claim 1 or 2,
wherein the solder joint is part of a solar cell; and wherein the first conductive structure comprises a solar cell connector wire or solar cell connector ribbon; and wherein the second conductive structure comprises a solar cell metallization structure.

4. The method (200) of claim 1 or 2,
wherein the solder joint is part of a solar panel and wherein the first conductive structure comprises a solar panel cross connector; and
wherein the second conductive structure comprises a solar cell connector wire or solar cell connector ribbon.

5. The method (200) of claim 1 or 2,
wherein the solder joint is part of a solar panel and wherein the first conductive structure comprises a solar panel junction box; and
wherein the second conductive structure comprises a solar panel cross connector.

6. The method (200) of any one of claims 1 to 5,
wherein the measuring temperature comprises measuring a plurality of temperature values; and.
wherein the plurality of temperature values are measured at at least one of different times and different locations of the second conductive structure.

7. The method (200) of any one of claims 1 to 6,
wherein the applying heat comprises applying heat by means of a laser.

8. The method (200) of any one of claims 1 to 7,
wherein the measuring temperature comprises measuring the temperature by means of a contact-free sensor.

9. The method (200) of any one of claims 1 to 8,
wherein the measuring temperature comprises measuring the temperature by means of at least one of at least one heat image camera and at least one pyrometer.

10. The method (200) of any one of claims 1 to 9, further comprising:
determining a temperature trend based on the applied heat and the measured temperature; and/or
comparing the temperature trend with a reference heat and a reference temperature trend.

11. An arrangement for checking a solder joint comprising at least a first conductive structure, a solder and a second conductive structure, the arrangement comprising:
a support structure configured to support a device including the solder joint;
a heater configured to apply heat to at least a portion of the first conductive structure;
a temperature sensor configured to measure temperature of a part of the second conductive structure; and
a processor coupled to the heater and the temperature sensor, the processor being configured to determine the degree of conductive coupling between the first conductive structure and the second conductive structure based on the applied heat and the measured temperature.

12. The arrangement of claim 11,
wherein the first conductive structure comprises a solar cell connector wire or solar cell connector ribbon or a solar panel cross connector or a solar panel junction box; and
wherein the second conductive structure comprises a solar cell metallization structure or a solar cell connector wire or solar cell connector ribbon or a solar panel cross connector.

13. The arrangement of any one of claims 11 or 12,
wherein the heater comprises a laser.

14. The arrangement of any one of claims 11 to 13,
wherein the temperature sensor comprises at least one of at least one heat image camera and at least one pyrometer.

15. The arrangement of any one of claims 11 to 14,
wherein the processor is configured to determine a temperature trend based on the applied heat and the measured temperature; and
comparing the temperature trend with a reference heat and a reference temperature trend.

## Amended claims

### Amended claims in accordance with Rule 137(2) EPC.

**1.** A method (200) for checking a solder joint of a solar cell, wherein the solder joint comprises at least a solar cell connector wire or solar cell connector ribbon, a conductive coupling and a solar cell metallization structure, the method (200) comprising:
applying heat to at least a portion of the solar cell connector wire or solar cell connector ribbon (202);
measuring temperature of at least one of part of the solar cell metallization structure and a part of the solar cell connector wire or solar cell connector ribbon (204); and
determining the degree of conductive coupling between the solar cell connector wire or solar cell connector ribbon and the solar cell metallization structure based on the applied heat and the measured temperature as a function for the solder joint solidity (206).

**2.** A method (200) for checking a solder joint of a solar panel, wherein the solder joint comprises at least a solar panel cross connector, a conductive coupling and a solar cell connector wire or solar cell connector ribbon, the method (200) comprising:
applying heat to at least a portion of the solar panel cross connector (202);
measuring temperature of at least one of a part of the solar cell connector wire or solar cell connector ribbon and a part of the solar panel cross connector (204); and
determining the degree of conductive coupling between the solar panel cross connector and the solar cell connector wire or solar cell connector ribbon based on the applied heat and the measured temperature as a function for the solder joint solidity (206).

**3.** A method (200) for checking a solder joint of a solar panel, wherein the solder joint comprises at least a solar panel junction box, a conductive coupling and a solar panel cross connector, the method (200) comprising:
applying heat to at least a portion of the solar panel junction box (202);
measuring temperature of at least one of a part of the solar panel cross connector (202) and a part of the solar panel junction box (204); and
determining the degree of conductive coupling between the solar panel junction box and the solar panel cross connector based on the applied heat and the measured temperature as a function for the solder joint solidity (206).

**4.** The method (200) of any one of claims 1 to 3,
wherein at least one of the solar cell connector wire or solar cell connector ribbon; the solar cell metallization structure; the solar panel junction box; and the solar panel cross connector comprises metal.

**5.** The method (200) of any one of claims 1 to 4,
wherein the measuring temperature comprises measuring a plurality of temperature values; and.
wherein the plurality of temperature values are measured at at least one of different times and different locations of the solar cell metallization structure, of the solar cell connector wire or solar cell connector ribbon, of the solar panel cross connector, or of the solar panel junction box.

**6.** The method (200) of any one of claims 1 to 5,
wherein the applying heat comprises applying heat by means of a laser.

**7.** The method (200) of any one of claims 1 to 6,
wherein the measuring temperature comprises measuring the temperature by means of a contact-free sensor.

**8.** The method (200) of any one of claims 1 to 7,
wherein the measuring temperature comprises measuring the temperature by means of at least one of at least one heat image camera and at least one pyrometer.

**9.** The method (200) of any one of claims 1 to 8, further comprising:
determining a temperature trend based on the applied heat and the measured temperature; and/or
comparing the temperature trend with a reference heat and a reference temperature trend.

**10.** An arrangement for checking a solder joint of a solar cell or a solar panel, wherein the solder joint comprises at least a solar cell connector wire or solar cell connector ribbon or a solar panel cross connector or a solar panel junction box, a solder and a solar cell metallization structure or a solar cell connector wire or solar cell connector ribbon or a solar panel cross connector, the arrangement comprising:
a support structure configured to support a device including the solder joint;
a heater configured to apply heat to at least a portion of the solar cell connector wire or solar cell connector ribbon or a solar panel cross connector or a solar panel junction box;
a temperature sensor configured to measure temperature of a part of the solar cell metallization structure or a solar cell connector wire or solar cell connector ribbon or a solar panel cross connector; and
a processor coupled to the heater and the temperature sensor, the processor being configured to determine the degree of conductive coupling between the solar cell connector wire or solar cell connector ribbon or a solar panel cross connector or a solar panel junction box and the solar cell metallization structure or a solar cell connector wire or solar cell connector ribbon or a solar panel cross connector based on the applied heat and the measured temperature.

**11.** I. The arrangement of claim 10,
wherein the heater comprises a laser.

**12.** The arrangement of any one of claims 10 to 11,
wherein the temperature sensor comprises at least one of at least one heat image camera and at least one pyrometer.

**13.** The arrangement of any one of claims 10 to 12,
wherein the processor is configured to determine a temperature trend based on the applied heat and the measured temperature; and
comparing the temperature trend with a reference heat and a reference temperature trend.
